(19) Europäisches Patentamt
European Patent Office
Office européen des brevets

(11) **EP 4 330 695 B1**

(12) **FASCICULE DE BREVET EUROPEEN**

(45) Date de publication et mention
de la délivrance du brevet:
**12.03.2025   Bulletin 2025/11**

(21) Numéro de dépôt: **21740114.0**

(22) Date de dépôt: **29.04.2021**

(51) Classification Internationale des Brevets (IPC):
*G01R 31/378* $^{(2019.01)}$     *G01R 31/367* $^{(2019.01)}$
*G01R 31/382* $^{(2019.01)}$     *G01R 31/392* $^{(2019.01)}$

(52) Classification Coopérative des Brevets (CPC):
**G01R 31/378; G01R 31/367; G01R 31/382;**
**G01R 31/392;** G01R 31/3842; Y02E 60/10

(86) Numéro de dépôt international:
**PCT/FR2021/000043**

(87) Numéro de publication internationale:
**WO 2022/229516 (03.11.2022 Gazette 2022/44)**

(54) **PROCEDE DE PREDICTION PAR INTELLIGENCE ARTIFICIELLE DE LA DUREE DE VIE RESTANTE D'UN ELEMENT ELECTROCHIMIQUE DE BATTERIE ET DISPOSITIFS ASSOCIES**

VERFAHREN ZUR VORHERSAGE DER RESTLEBENSDAUER EINER ELEKTROCHEMISCHEN BATTERIEZELLE DURCH KÜNSTLICHE INTELLIGENZ UND ZUGEHÖRIGE VORRICHTUNGEN

METHOD FOR PREDICTING BY ARTIFICIAL INTELLIGENCE THE REMAINING LIFE OF AN ELECTROCHEMICAL BATTERY CELL AND ASSOCIATED DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**06.03.2024   Bulletin 2024/10**

(73) Titulaire: **SAFT**
**92300 Levallois-Perret (FR)**

(72) Inventeurs:
• **LAURENT, Sebastien**
**33700 Merignac (FR)**
• **DAHMANI, Mouna**
**33000 Bordeaux (FR)**
• **BENJAMIN, Sebastien**
**33850 Leognan (FR)**

(74) Mandataire: **Lavoix**
**2, place d'Estienne d'Orves**
**75441 Paris Cedex 09 (FR)**

(56) Documents cités:
**EP-A1- 3 364 203**

• **XUE QIAO ET AL: "Remaining Useful Life Prediction for Lithium-Ion Batteries Based on Capacity Estimation and Box-Cox Transformation", IEEE TRANSACTIONS ON VEHICULAR TECHNOLOGY, IEEE, USA, vol. 69, no. 12, 23 November 2020 (2020-11-23), pages 14765 - 14779, XP011833884, ISSN: 0018-9545, [retrieved on 20210122], DOI: 10.1109/ TVT.2020.3039553**
• **NIANKAI YANG ET AL: "Robust State of Health Estimation of Lithium-ion Batteries Using Convolutional Neural Network and Random Forest", ARXIV.ORG, CORNELL UNIVERSITY LIBRARY, 201 OLIN LIBRARY CORNELL UNIVERSITY ITHACA, NY 14853, 20 October 2020 (2020-10-20), XP081791116**

## Description

La présente invention concerne un procédé de prédiction d'un paramètre relatif à la durée de vie restante d'au moins un élément électrochimique d'une batterie. La présente invention se rapporte aussi à un calculateur, un système de gestion et une batterie associés.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de santé est une information utile au système électronique de gestion de la batterie pour optimiser son utilisation et sa durée de vie. L'état de santé est souvent désigné sous l'abréviation SOH qui renvoie à la dénomination anglaise de « State of Health ».

L'état de santé SOH permet d'estimer le vieillissement de la batterie entre un état neuf et un état fin de vie, ou plus généralement, entre un état initial et un état final.

Une technique de détermination de l'état de santé SOH est une technique dans laquelle les valeurs de température, de tension, et éventuellement de courant de la batterie sont surveillées pour déterminer une valeur de l'état de santé SOH à partir de lois de vieillissement. De telles lois de vieillissement sont obtenues à partir d'essais réalisés en laboratoire. L'application des lois de vieillissement aux valeurs surveillées donne ainsi une estimation du vieillissement de la batterie.

Toutefois, cette technique de type statique suppose un vieillissement homogène des accumulateurs de la batterie et un circuit de puissance sans défaillance entre les accumulateurs.

Une autre technique de détermination de l'état de santé SOH est une technique dans laquelle est calculé le rapport de la résistance de la batterie à un instant donné par mesure de la tension et du courant sur la résistance de la batterie à l'état neuf ou initial dans les mêmes conditions de mesure (notamment dans les mêmes conditions de température). De fait, la résistance augmente avec le vieillissement de la batterie, traduisant une perte de puissance. Dans un tel cas, l'expression état de santé SOH lié à la résistance de la batterie est souvent utilisée ou son abréviation SOHR qui renvoie à la dénomination anglaise correspondante de « State of Health related to battery Resistance ».

Il est également connu de caractériser une résistance sur un échelon de courant.

Une telle technique consiste à mesurer le rapport entre la variation de tension et la variation de courant. Mais une telle solution nécessite un cycle additionnel spécifique, et n'est donc pas réalisable de façon native car il implique la présence d'un chargeur avec une capacité d'impulsion significative, ce qui est contraignant pour l'utilisateur.

En outre, une telle technique est difficilement reproductible à l'usage car le temps de l'impulsion, la valeur d'état de charge au moment où l'impulsion est réalisée, ainsi que le courant de l'impulsion, sont autant de variables qui influent sur la mesure de la résistance.

De plus, même si la technique était réalisable et reproductible, l'évolution des propriétés chimiques de l'élément avec le vieillissement implique une modification de certains paramètres internes comme les constantes de temps par exemple. Aussi, une telle technique ne permet pas de donner une information significative sur le vieillissement réel. En conséquence, ce vieillissement est bien souvent minimisé lorsque la résistance est estimée sur la zone transitoire d'un échelon de courant.

Il est également connu d'obtenir l'état de santé SOH à partir du rapport de la capacité de la batterie à un instant donné sur la capacité de la batterie à l'état neuf ou initial dans les mêmes conditions de mesure (notamment dans les mêmes conditions de température). De fait, la capacité diminue avec le vieillissement, traduisant une perte d'énergie disponible. Dans un tel cas, l'expression état de santé SOH lié à la capacité de la batterie est souvent utilisée ou son abréviation SOHC qui renvoie à la dénomination anglaise correspondante de « State of Health related to battery Capacity ».

Dans certains éléments électrochimiques, du fait que la variation de la tension en circuit ouvert en fonction de l'état de charge présente un plateau, les calculs possibles sont limités car il n'est pas possible d'associer de manière précise un état de charge à une mesure de tension.

Pour ce type d'élément, le vieillissement en capacité peut être déterminé sur une décharge complète lors d'un cycle de maintenance.

Une autre technique pour déterminer le vieillissement en capacité est d'observer l'allure de la déformation de l'élément sur un cycle partiel.

Toutefois, ces méthodes ne permettent pas de déterminer le vieillissement en résistance d'une batterie.

Il est également connu d'autres techniques de détermination de la durée de vie restante des documents suivants :

- un article de Xue Qiao et al. intitulé « Remaining Useful Life Prediction for Lithium-Ion Batteries Based on Capacity Extimation and Box-Cox Transformation" (IEEE Transactions on Vehicular Technology, IEEE, USA, vol. 69, no. 12, 23 novembre 2020),
- un article de Niankai Yang et al. intitulé « Robust State of Health Extimation of Lithium-Ion Batteries Using Convolutionnal Neural Network and Random Forest" (Arxiv.org, Cornell University Library, 201 Olin Library Cornell University Ithaca, NY 14853, 20 octobre 2020), et
- le document EP 3 364 203 A1.

Il existe donc un besoin pour un procédé de prédiction d'un paramètre relatif à la durée de vie restante d'un élément électrochimique d'une batterie qui permette d'obtenir une détermination précise du paramètre pour un élément électrochimique présentant un plateau dans la caractéristique tension en circuit ouvert - état de charge.

A cet effet, la description décrit un procédé de prédiction d'un paramètre relatif à la durée de vie restante d'au moins un élément électrochimique d'une batterie, l'au moins un élément électrochimique présentant une résistance, une capacité et une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane s'étendant entre une première extrémité correspondant à une première valeur d'état de charge et une deuxième extrémité correspondant à une deuxième valeur d'état de charge. Le procédé est mis en œuvre par un calculateur et le procédé comprend une étape d'obtention des mesures de la tension et du courant de l'au moins un élément électrochimique lors d'une décharge comprenant une extrémité de la portion plane et commençant à un instant initial, une étape de détection d'une extrémité de la portion plane en utilisant un critère dépendant de la tension et du courant, une étape de calcul des valeurs à l'extrémité détectée d'un premier paramètre et d'un deuxième paramètre, le premier paramètre étant un paramètre relatif à la tension et le deuxième paramètre étant un paramètre relatif à la quantité de charge perdue depuis l'instant initial, une étape de prédiction de la résistance de l'au moins un élément électrochimique par application d'une première fonction de prédiction sur des premiers paramètres d'entrée, les premiers paramètres d'entrée comprenant la valeur du premier paramètre à l'extrémité détectée et la valeur du deuxième paramètre à l'extrémité détectée, la première fonction de prédiction étant obtenue par une première technique d'apprentissage, pour obtenir une valeur de résistance prédite. Le procédé de prédiction comprend également une étape de prédiction de la capacité de l'au moins un élément électrochimique par application d'une deuxième fonction de prédiction sur des deuxièmes paramètres d'entrée, les deuxièmes paramètres d'entrée comprenant la valeur du premier paramètre à l'extrémité détectée et la valeur du deuxième paramètre à l'extrémité détectée, la deuxième fonction de prédiction étant obtenue par une deuxième technique d'apprentissage, pour obtenir une valeur de capacité prédite, et une étape de prédiction d'un paramètre relatif à la durée de vie restante de l'au moins un élément électrochimique à partir de la valeur de résistance prédite et de la valeur de capacité prédite.

Selon des modes de réalisation particuliers, le procédé de prédiction présente une ou plusieurs des caractéristiques suivantes, prise(s) isolément ou selon toutes les combinaisons techniquement possibles :

- l'étape de prédiction d'un paramètre relatif à la durée de vie est mise en œuvre par application d'une troisième fonction de prédiction sur des troisièmes paramètres d'entrée, les troisièmes paramètres d'entrée comprenant la valeur de la résistance prédite, la valeur de la capacité prédite, la valeur du premier paramètre à l'extrémité détectée et la valeur du deuxième paramètre à l'extrémité détectée, la troisième fonction de prédiction étant obtenue par une troisième technique d'apprentissage.
- la troisième technique utilise un algorithme de vecteur autorégressif.
- lors de l'étape d'obtention, il est également obtenu des mesures de température de l'au moins un élément électrochimique lors de la décharge et lors de l'étape de calcul, la valeur du courant à l'extrémité détectée et la valeur de la température à l'extrémité détectée sont également calculées, les premiers paramètres d'entrée et les deuxièmes paramètres d'entrée consistant en la valeur du courant à l'extrémité détectée, la valeur de la température à l'extrémité détectée, la valeur du premier paramètre et la valeur du deuxième paramètre.
- lors de l'étape de calcul, la valeur du courant à l'extrémité détectée et la valeur de la température à l'extrémité détectée sont également calculées, les premiers paramètres d'entrée consistant en la valeur du courant à l'extrémité détectée, la valeur de la température à l'extrémité détectée, la valeur du premier paramètre et la valeur du deuxième paramètre et les deuxièmes paramètres d'entrée consistant en la valeur du courant à l'extrémité détectée, la valeur de la température à l'extrémité détectée, la valeur du premier paramètre, la valeur du deuxième paramètre et la résistance estimée.

- la première technique utilise un algorithme choisi parmi un algorithme de forêts aléatoires, un algorithme de K plus proches voisins, un algorithme de régression à vecteurs de support et un algorithme de régression polynomiale et la deuxième technique utilise un algorithme choisi parmi un algorithme de forêts aléatoires et un algorithme de K plus proches voisins.

- lorsque l'extrémité détectée est la première extrémité, le premier paramètre est la tension et le deuxième paramètre est la dérivée de la quantité de charge perdue depuis l'instant initial par rapport à la tension, le critère utilisé à l'étape de détection étant que le deuxième paramètre soit inférieur à un seuil.

- lorsque l'extrémité détectée est la première extrémité, le premier paramètre est la tension et le deuxième paramètre est la quantité de charge perdue depuis l'instant initial, le critère de détection étant que la variation du premier paramètre à quantité de charge perdue fixée soit inférieure à un seuil.

- l'au moins un élément électrochimique est un élément électrochimique de type LiFePO4, LiMnFePO4 ou LVPF.

La description propose également un calculateur propre à prédire un paramètre relatif à la durée de vie restante d'au moins un élément électrochimique d'une batterie, l'au moins un élément électrochimique présentant une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane s'étendant entre une première extrémité correspondant à une première valeur d'état de charge et une deuxième extrémité correspondant à une deuxième valeur d'état de charge. Le calculateur est propre à obtenir des mesures de la tension et du courant de l'au moins un élément électrochimique lors d'une décharge comprenant une extrémité de la portion plane et commençant à un instant initial, à détecter une extrémité de la portion plane en utilisant un critère dépendant de la tension et du courant, à calculer des valeurs à l'extrémité détectée d'un premier paramètre et d'un deuxième paramètre, le premier paramètre étant un paramètre relatif à la tension et le deuxième paramètre étant un paramètre relatif à la quantité de charge perdue depuis l'instant initial et à prédire la résistance de l'au moins un élément électrochimique par application d'une première fonction de prédiction sur des premiers paramètres d'entrée, les premiers paramètres d'entrée comprenant la valeur du premier paramètre à l'extrémité détectée et la valeur du deuxième paramètre à l'extrémité détectée, la première fonction de prédiction étant obtenue par une première technique d'apprentissage, pour obtenir une valeur de résistance prédite. Le calculateur est également propre à prédire la capacité l'au moins un élément électrochimique par application d'une deuxième fonction de prédiction sur des deuxièmes paramètres d'entrée, les deuxièmes paramètres d'entrée comprenant la valeur du premier paramètre à l'extrémité détectée et la valeur du deuxième paramètre à l'extrémité détectée, la deuxième fonction de prédiction étant obtenue par une deuxième technique d'apprentissage, pour obtenir une valeur de capacité prédite, et à prédire un paramètre relatif à la durée de vie restante de l'au moins un élément électrochimique à partir de la valeur de résistance prédite et de la valeur de capacité prédite.

La description décrit aussi un système de gestion d'au moins un élément électrochimique d'une batterie, l'au moins un élément électrochimique présentant des bornes et une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane s'étendant entre une première extrémité correspondant à une première valeur d'état de charge et une deuxième extrémité correspondant à une deuxième valeur d'état de charge, le système de gestion comprenant un capteur de tension propre à mesurer la tension aux bornes dudit au moins un élément électrochimique lors d'une décharge comprenant la portion plane, un capteur du courant aux bornes dudit au moins un élément électrochimique lors d'une décharge comprenant la portion plane, et un calculateur tel que précédemment décrit.

La description propose également une batterie comprenant au moins un élément électrochimique, l'au moins un élément électrochimique présentant des bornes et une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane s'étendant entre une première extrémité correspondant à une première valeur d'état de charge et une deuxième extrémité correspondant à une deuxième valeur d'état de charge, et un système de gestion tel que précédemment décrit.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un exemple de batterie comportant un élément électrochimique,
- la figure 2 est un graphe illustrant un exemple de caractéristique état de charge - tension en circuit ouvert de l'élément électrochimique, et
- la figure 3 est un ordinogramme d'un exemple de mise en œuvre de procédé de prédiction d'un paramètre relatif à la durée de vie restante.

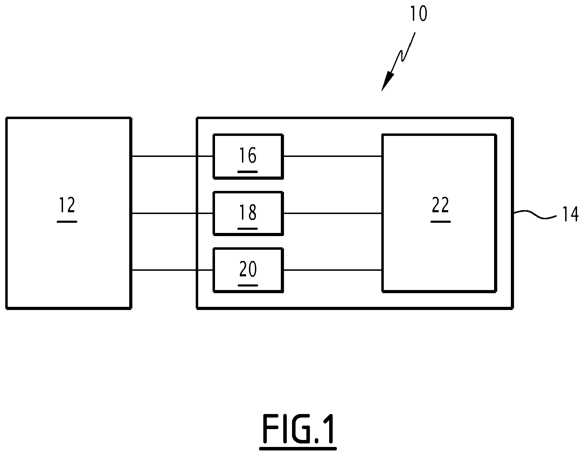

Une batterie 10 est représentée sur la figure 1.

De manière connue en soi, une batterie est généralement un agencement d'une pluralité d'éléments électrochimiques mais dans un souci de simplification du propos, il est décrit un cas à un seul élément électrochimique dans ce qui suit, sachant que la transposition à d'autres agencements est immédiate.

La batterie 10 comporte un élément électrochimique 12 et un système de gestion 14 de l'élément électrochimique 12.

Comme expliqué précédemment, un élément électrochimique 12 est un dispositif de production d'électricité dans lequel de l'énergie chimique est convertie en énergie électrique.

L'élément électrochimique 12 délivre donc un courant et une tension entre deux bornes.

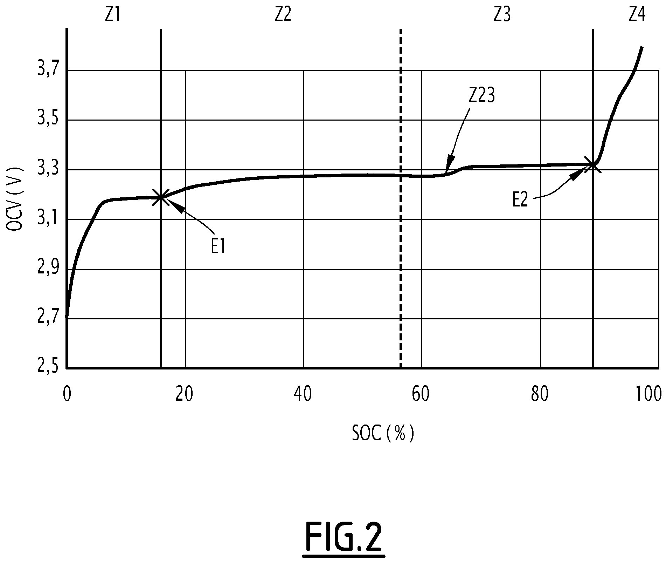

L'élément électrochimique 12 présente une caractéristique état de charge - tension en circuit ouvert telle que visible sur la figure 2.

L'état de charge est souvent désigné par l'abréviation SOC qui renvoie à la dénomination anglaise de « State of Charge ». La tension en circuit ouvert est souvent désignée par l'abréviation OCV qui renvoie à la dénomination anglaise de « Open Circuit Voltage ». Aussi la caractéristique état de charge - tension en circuit ouvert est notée caractéristique SOC/OCV dans la suite.

Dans la figure 2, l'état de charge SOC est exprimé en pourcentage d'un état de charge maximale.

La caractéristique SOC/OCV présente quatre zones, une première zone Z1, une deuxième zone Z2, une troisième zone Z3 et une quatrième zone Z4.

La première zone Z1 correspond au début de la charge et la quatrième zone Z4 à la fin de la charge.

Pour les deux zones intermédiaires, dans la mesure où les deuxième zone Z2 et troisième zone Z3 correspondent à une portion plane, il sera utilisé la dénomination portion plane Z23 dans la suite.

La portion plane Z23 est une portion dans laquelle la variation de tension en circuit ouvert OCV est inférieure à 30 mV (millivolt) pour une variation d'au moins 10% de l'état de charge SOC.

La portion plane s'étend entre deux extrémités E1 correspondant à une première valeur d'état de charge SOC et E2 correspondant à une deuxième valeur d'état de charge SOC.

Un tel type de caractéristique SOC/OCV se retrouve notamment lorsque l'élément électrochimique 12 est un élément électrochimique de type $LiFePO_4$, $LiMnFePO_4$, ou LVPF.

On entend par élément électrochimique de type $LiFePO_4$ ou $LiMnFePO_4$, un élément électrochimique dont l'électrode positive (cathode) comprend un ou des matériaux électrochimiquement actifs dont l'un au moins est à base d'un phosphate lithié d'au moins un métal de transition, de formule $Li_xFe_{1-y}M_yPO_4$, où M est choisi dans le groupe consistant en B, Mg, Al, Si, Ca, Ti, V, Cr, Mn, Co, Ni, Cu, Zn, Y, Zr, Nb et Mo; $0,8 \leq x \leq 1,2$ ; et $0 \leq y \leq 0,6$.

On entend par élément électrochimique de type LVPF, un élément électrochimique dont l'électrode positive (cathode) comprend un ou des matériaux électrochimiquement actifs dont l'un au moins est à base d'un composé de type $LiVPO_4F$.

Le système de gestion 14 est un système propre à gérer l'élément électrochimique 12.

Le système de gestion 14 comporte un capteur de tension 16, un capteur de courant 18, un capteur de température 20 et un calculateur 22.

Le capteur de tension 16 est propre à mesurer la tension aux bornes de l'élément électrochimique 12.

Le capteur de courant 18 est propre à mesurer le courant aux bornes de l'élément électrochimique 12.

Le capteur de température 20 est propre à mesurer la température de l'élément électrochimique 12.

Le calculateur 22 est propre à mettre en œuvre un procédé de prédiction d'un paramètre relatif à la durée de vie restante.

Le calculateur 22 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 22 comprend un processeur monocœur ou multicœurs (tel qu'une unité de traitement centrale (CPU), une unité de traitement graphique (GPU), un microcontrôleur et un processeur de signal numérique (DSP)), un circuit logique programmable (comme un circuit intégré spécifique à une application (ASIC), un réseau de portes programmables *in situ* (FPGA), un dispositif logique programmable (PLD) et des réseaux logiques programmables (PLA)), une machine à états, une porte logique et des composants matériels discrets.

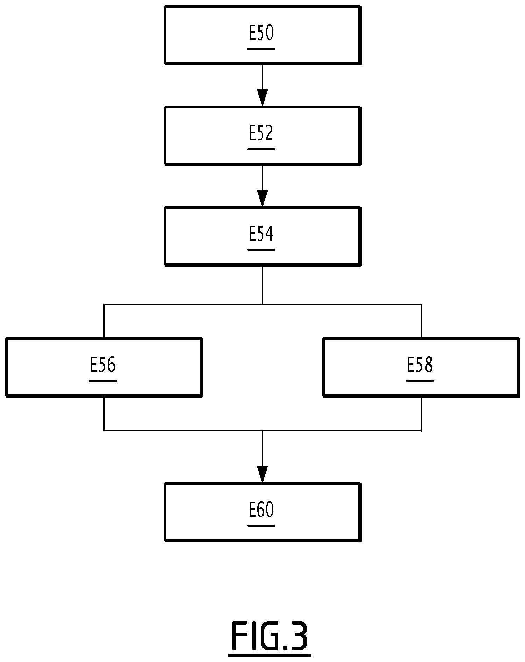

Un exemple de mise en œuvre du procédé de prédiction d'un paramètre relatif à la durée de vie restante est maintenant décrit en référence à l'ordinogramme de la figure 3.

Le procédé de prédiction comporte une étape d'obtention E50, une étape de détection E52, une étape de calcul E54, une première étape de prédiction E56, une deuxième étape de prédiction E58 et une étape de prédiction E60.

Lors de l'étape d'obtention E50, le calculateur 22 obtient des mesures de la tension V et du courant I de l'élément électrochimique 12 lors d'une décharge comprenant une extrémité de la portion plane Z23.

Dans l'exemple de la figure 3, l'extrémité est la deuxième extrémité E2.

La décharge commence à un instant initial T0.

La charge à l'instant initial T0 est maximale de sorte que la décharge commence à l'extrémité de la quatrième zone Z4.

En variante, la charge à l'instant initial T0 est plus faible que la charge maximale mais suffisante pour que la décharge commence toujours dans la quatrième zone Z4.

Lors de l'étape de détection E52, le calculateur 22 détecte la deuxième extrémité E2 de la portion plane Z23.

Pour cela, le calculateur 22 détermine qu'un critère dépendant de la tension et du courant de l'élément électrochimique 12 est rempli.

En l'occurrence, le critère est une condition à remplir par la valeur de la tension.

En l'espèce, la valeur de la tension est comparée à un seuil à pas constant de quantité de charge perdue depuis l'instant initial T0.

Cela suppose que le calculateur 22 calcule en permanence la quantité de charge perdue depuis l'instant initial T0 (exprimée en Ampère-heure).

Aussi, la quantité de charge perdue depuis l'instant initial T0 s'obtient comme la somme des valeurs de courants à plusieurs instants de mesure multipliées chacune par le temps écoulé entre l'instant de mesure et l'instant de mesure précédent.

Lorsque la valeur de tension est inférieure au seuil, le calculateur 22 détecte la fin de la quatrième zone, c'est-à-dire la deuxième extrémité E2 de la portion plane Z23.

Lors de l'étape de calcul E54, le calculateur 22 calcule les valeurs à la deuxième extrémité E2 d'un premier paramètre P1 et d'un deuxième paramètre P2.

Le premier paramètre P1 est un paramètre relatif à la tension.

En l'espèce, le premier paramètre P1 est la valeur de la tension de l'élément électrochimique 12.

La valeur du premier paramètre P1 à la deuxième extrémité E2 est notée $V_{min}^{Z4}$.

Le deuxième paramètre P2 est un paramètre relatif à la quantité de charge perdue depuis l'instant initial T0.

En l'espèce, le deuxième paramètre P2 est la quantité de charge perdue depuis l'instant initial T0.

La valeur du deuxième paramètre P2 à la deuxième extrémité E2 est notée $Q_{dch}^{Z4}$.

Les valeurs $V_{min}^{Z4}$ et $Q_{dch}^{Z4}$ des deux paramètres P1 et P2 ainsi calculés par le calculateur 22 sont utilisées dans les étapes suivantes.

Lors de la première étape de prédiction E56, le calculateur 22 prédit la résistance de l'élément électrochimique 12.

Plus précisément, le calculateur 22 prédit la valeur de la résistance de l'élément électrochimique 12 à la deuxième extrémité E2.

Pour cela, le calculateur 22 applique une première fonction de prédiction F1 sur des premiers paramètres d'entrée PE1 pour obtenir en sortie une valeur de résistance prédite $R_p^{E2}$ correspondant à la valeur de la résistance de l'élément électrochimique 12 à la deuxième extrémité E2.

Les premiers paramètres d'entrée PE1 comprennent la valeur $V_{min}^{Z4}$ du premier paramètre P1 et la valeur $Q_{dch}^{Z4}$ du deuxième paramètre P2.

La première fonction F1 est obtenue par une technique d'apprentissage automatique, notée première technique T1 dans la suite.

Selon l'exemple décrit, la première technique T1 utilise un algorithme de forêt aléatoire.

L'algorithme de forêt aléatoire est plus souvent dénommé sous l'appellation anglaise correspondante de « random forest ».

La première technique T1 est ainsi une technique d'apprentissage des paramètres libres de l'algorithme de forêt aléatoire à partir d'un jeu de données obtenu par des expériences réelles en laboratoire, typiquement pour plus de 100 éléments électrochimiques 12 différents.

Durant ces expériences, des éléments électrochimiques 12 subissent des cycles successifs et les valeurs électriques de ces éléments électrochimiques 12 sont relevées pour former le jeu de données.

Le jeu de données est ensuite séparé en jeu d'entraînement et jeu de test, selon par exemple une proportion de 80%-20%.

Le jeu d'entraînement est utilisé pour que l'algorithme de forêt aléatoire apprenne ses différents paramètres libres par itérations successives jusqu'à vérifier un critère de performance souhaitée. Il est ainsi obtenu un modèle.

Le jeu de test sert ensuite à évaluer la performance du modèle obtenu.

Le modèle obtenu est la première fonction de prédiction F1.

L'apprentissage est effectué préalablement de sorte que seule la première fonction de prédiction F1 est mémorisée par le calculateur 22.

L'application de la première fonction de prédication F1 sur la valeur $V_{min}^{Z4}$ du premier paramètre P1 et la valeur $Q_{dch}^{Z4}$ du deuxième paramètre P2 permet ainsi d'obtenir la valeur de résistance prédite $R_p^{E2}$.

Lors de la deuxième étape de prédiction E58, le calculateur 22 prédit la capacité de l'élément électrochimique 12.

Plus précisément, le calculateur 22 prédit la valeur de la capacité de l'élément électrochimique 12 à la deuxième extrémité E2.

Pour cela, le calculateur 22 applique une deuxième fonction de prédiction F2 sur des deuxièmes paramètres d'entrée PE2 pour obtenir en sortie une valeur de capacité prédite $C_p^{E2}$ correspondant à la valeur de la capacité de l'élément électrochimique 12 à la deuxième extrémité E2.

Les deuxièmes paramètres d'entrée PE2 comprennent la valeur $V_{min}^{Z4}$ du premier paramètre P1 et la valeur $Q_{dch}^{Z4}$ du deuxième paramètre P2.

La deuxième fonction F2 est obtenue par une technique d'apprentissage automatique, notée deuxième technique T2 dans la suite.

Selon l'exemple décrit, la deuxième technique T2 utilise également un algorithme de forêt aléatoire.

La deuxième technique T2 est ainsi une technique d'apprentissage des paramètres libres de l'algorithme de forêt aléatoire à partir d'un jeu de données obtenu par des expériences réelles en laboratoire pouvant être les mêmes que pour la première technique T1. Seul le contenu des données change puisque la donnée à prédire est différente.

Le jeu de données est ensuite séparé en jeu d'entraînement et jeu de test, selon par exemple une proportion de 80%-20%.

Le jeu d'entraînement est utilisé pour que l'algorithme de forêt aléatoire apprenne ses différents paramètres libres par itérations successives jusqu'à vérifier un critère de performance souhaitée. Il est ainsi obtenu un modèle. Il est à noter que les paramètres libres du modèle obtenu avec la deuxième technique T2 ne sont pas les mêmes que ceux obtenus avec la première technique T1.

Le jeu de test sert ensuite à évaluer la performance du modèle obtenu avec la deuxième technique T2.

Le modèle obtenu avec la deuxième technique T2 est la deuxième fonction de prédiction F2.

L'apprentissage est effectué préalablement de sorte que seule la deuxième fonction de prédiction F2 est mémorisée par le calculateur 22.

L'application de la deuxième fonction de prédication F2 sur la valeur $V_{min}^{Z4}$ du premier paramètre P1 et la valeur $Q_{dch}^{Z4}$ du deuxième paramètre P2 permet ainsi d'obtenir la valeur de capacité prédite $C_p^{E2}$.

Selon l'exemple de la figure 3, la première étape de prédiction E56 et la deuxième étape de prédiction E58 sont mises en œuvre simultanément.

En effet, les deux fonctions de prédiction F1 et F2 ont des paramètres d'entrées PE1 et PE2 qui sont disponibles au même instant.

Lors de l'étape de prédiction E60, le calculateur 22 prédit un paramètre relatif à la durée de vie restante de l'élément électrochimique 12 en utilisant la valeur de capacité prédite $C_p^{E2}$ et la valeur de résistance prédite $R_p^{E2}$.

Dans l'exemple de la figure 3, le paramètre relatif à la durée de vie restante de l'élément électrochimique 12 est la durée de vie restante de l'élément électrochimique 12.

En outre, dans l'exemple décrit, le calculateur 22 prédit la valeur de la durée de vie restante de l'élément électrochimique 12.

Pour cela, le calculateur 22 applique une troisième fonction de prédiction F3 sur des troisièmes paramètres d'entrée PE3 pour obtenir en sortie la valeur de la durée de vie restante de l'élément électrochimique 12.

Les troisièmes paramètres d'entrée PE3 comprennent la valeur de capacité prédite $C_p^{E2}$, la valeur de résistance prédite $R_p^{E2}$ et le temps d'utilisation de l'élément électrochimique 12. Par exemple, le temps d'utilisation de l'élément électrochimique 12 est le temps écoulé depuis le début de l'utilisation par l'utilisateur final du dispositif comprenant l'élément électrochimique 12.

La troisième fonction F3 est obtenue par une technique d'apprentissage automatique, notée troisième technique T3 dans la suite.

Selon l'exemple décrit, la troisième technique T3 utilise un algorithme de vecteur autorégressif.

La troisième technique T3 est ainsi une technique d'apprentissage des paramètres libres de l'algorithme de vecteur autorégressif à partir d'un jeu de données obtenu par des expériences réelles en laboratoire pouvant être les mêmes que pour la première technique T1. Seul le contenu des données change puisque la donnée à prédire est différente.

Le jeu de données est ensuite séparé en jeu d'entraînement et jeu de test, selon par exemple une proportion de 80%-20%.

Le jeu d'entraînement est utilisé pour que l'algorithme de vecteur autorégressif apprenne ses différents paramètres libres par itérations successives jusqu'à vérifier un critère de performance souhaitée. Il est ainsi obtenu un modèle.

Le jeu de test sert ensuite à évaluer la performance du modèle obtenu avec la troisième technique T3.

Le modèle obtenu avec la troisième technique T3 est la troisième fonction de prédiction F3.

Plus précisément, il convient de comprendre que l'algorithme de vecteur autorégressif désigne ici abusivement un ensemble d'opérations, à savoir une opération correspondant à l'utilisation d'un modèle statistique appelé vecteur autorégressif (plus souvent désigné par l'abréviation VAR) et au moins une opération subséquente.

Comme son nom l'indique, la première opération utilise un modèle VAR qui est un modèle statistique utilisé pour obtenir les relations entre de multiples quantités variant temporellement. Le modèle VAR est un type particulier de modèle de processus stochastique. Un tel modèle peut être vu comme une généralisation d'un modèle autorégressif à une seule variable permettant l'emploi de série temporelles multivariées.

Dans un modèle VAR, la valeur actuelle d'une grandeur à prédire dépend ainsi des valeurs de toutes les grandeurs et des valeurs passées de ces grandeurs.

L'opération d'utilisation du modèle VAR permet, par exemple, de prédire le temps qui s'écoulera pour qu'une valeur de capacité prédéfinie de l'élément électrochimique 12 soit obtenue. La valeur prédéfinie dépend en pratique de l'application envisagée et notamment de la criticité de l'application. Par exemple, une valeur de 20% est acceptable pour certaines applications mais pour d'autres applications, ce sera une valeur de 25%.

Plus généralement, l'opération d'utilisation du modèle VAR permet de prédire le temps qui s'écoulera pour qu'une condition portant sur la résistance et/ou la capacité (correspondant généralement à un fonctionnement dégradé de l'élément électrochimique 12) soit vérifié. Ce temps correspond en fait à la durée de vie de l'élément électrochimique 12 prenant en compte l'utilisation effective de l'élément électrochimique 12.

Selon une deuxième opération, la durée de vie restante est alors calculée comme la différence entre le temps prédit et le temps déjà écoulé, c'est-à-dire le temps d'utilisation de l'élément électrochimique 12.

L'apprentissage est effectué préalablement de sorte que seule la troisième fonction de prédiction F3 est mémorisée par le calculateur 22.

L'application de la troisième fonction de prédiction F3 sur la valeur de capacité prédite $C_p^{E2}$, la valeur de résistance prédite $R_p^{E2}$ et le temps d'utilisation de l'élément électrochimique 12 permet ainsi d'obtenir la durée de vie restante de l'élément électrochimique 12.

La durée de vie restante ainsi déterminée présente l'avantage d'être précise.

En effet, des prédictions exactes à plus de 90% d'après les évaluations de la demanderesse ont été obtenues pour toutes les configurations expérimentales possibles.

En outre, le procédé de prédiction est relativement aisé à mettre en œuvre puisqu'il n'impose aucune contrainte de fonctionnement pour l'utilisateur de l'élément électrochimique.

En effet, il n'est pas imposé une séquence de charge ou de décharge qui ne se retrouve pas dans l'utilisation habituelle par l'utilisateur de l'élément électrochimique.

Le procédé est compatible avec d'autres algorithmes.

Ainsi, par exemple, la première technique T1 peut également utiliser un algorithme de K plus proches voisins. Un tel algorithme est souvent désigné par l'abréviation KNN qui renvoie à la dénomination anglaise correspondante de « k-nearest neighbors ».

En variante, la première technique T1 peut utiliser un algorithme régression à vecteurs de support. Un tel algorithme est souvent désigné par l'abréviation SVR qui renvoie à la dénomination anglaise correspondante de « support vector regression ».

Selon une autre variante, la première technique T1 peut utiliser un algorithme de régression polynomiale.

Chacun de ces algorithmes ont été testés par la demanderesse et donnent des performances satisfaisantes.

Similairement, la deuxième technique T2 peut utiliser un algorithme KNN.

La demanderesse a, en effet, montré que seuls les algorithmes de forêt aléatoire et KNN permettaient d'obtenir des performances satisfaisantes et notamment pas l'algorithme SVR ou la régression polynomiale.

Le procédé est également compatible avec d'autres paramètres d'entrée.

Aussi, à titre d'exemple, les premiers paramètres d'entrée et les deuxièmes paramètres d'entrée consistent en la valeur du courant à la deuxième extrémité E2, la valeur de la température à la deuxième extrémité E2, la valeur $V_{min}^{Z4}$ du premier paramètre P1 et la valeur $Q_{dch}^{Z4}$ du deuxième paramètre P2.

Pour cela, par exemple, lors de l'étape d'obtention E50, il est également obtenu des mesures de température de l'élément électrochimique 12 lors de la décharge et lors de l'étape de calcul E54, la valeur du courant à l'extrémité détectée et la valeur de la température à l'extrémité détectée sont également calculées.

Similairement, selon un mode de réalisation, les troisièmes paramètres d'entrée PE3 comprennent la valeur de capacité prédite $C_p^{E2}$, la valeur de résistance prédite $R_p^{E2}$ et le temps d'utilisation de l'élément électrochimique 12 mais également la valeur $V_{min}^{Z4}$ du premier paramètre P1 et la valeur $Q_{dch}^{Z4}$ du deuxième paramètre P2.

Selon un exemple, les troisièmes paramètres d'entrée PE3 consistent en le temps d'utilisation de l'élément électrochimique 12, la valeur du courant à la deuxième extrémité E2, la valeur de la température à la deuxième extrémité E2, la valeur de capacité prédite $C_p^{E2}$, la valeur de résistance prédite $R_p^{E2}$, la valeur $V_{min}^{Z4}$ du premier paramètre P1 et la valeur $Q_{dch}^{Z4}$ du deuxième paramètre P2.

Selon encore un autre exemple, le premier paramètre P1 est le rapport entre la tension et le courant au lieu de la tension (pour pouvoir corriger le courant).

Dans certains cas, il peut également être avantageux de considérer le rapport entre la tension diminuée de la tension en circuit ouvert OCV à la deuxième extrémité et le courant au lieu de la tension (pour pouvoir corriger le courant et la tension en circuit ouvert OCV).D'autres modes de réalisation du procédé sont également envisageables et sont maintenant décrits.

Selon un premier exemple, la première étape de détermination E56 et la deuxième étape de détermination E58 sont mises en œuvre séquentiellement.

En effet, dans un tel premier exemple, les deuxièmes paramètres d'entrée PE2 comportent également la valeur de résistance prédite $R_p^{E2}$ .

Avec une telle différence, la demanderesse a pu observer des améliorations dans les performances de prédiction de la valeur de capacité prédite $C_p^{E2}$ de l'ordre de 10%.

Le procédé de prédiction selon le premier exemple permet donc d'obtenir une meilleure prédiction de la durée de vie.

Selon un deuxième exemple, le procédé de prédiction n'utilise pas la deuxième extrémité E2 mais la première extrémité E1.

Des remarques similaires au cas décrit en référence à la figure 3 s'appliquent également dans ce cas.

Seules les différences sont soulignées dans ce qui suit.

Lors de l'étape d'obtention E50, à l'instant initial T0, l'état de charge SOC est situé sur la portion plane Z23.

En outre, le premier paramètre P1 est la tension et le deuxième paramètre P2 est la dérivée de la quantité de charge perdue depuis l'instant initial par rapport à la tension et le critère utilisé à l'étape de détection E52 est que le deuxième paramètre P2 soit inférieur à un seuil.

Le seuil est un seuil relativement faible pour correspondre à un maximum local.

La valeur de la dérivée est obtenue en calculant le rapport entre la différence entre deux quantités de charge perdue depuis l'instant initial et la différence entre les deux mesures de tension correspondantes.

La dérivée est calculée à chaque fois que la tension varie d'une quantité prédéfinie (pas).

Lors de l'étape de calcul E54, le calculateur 22 obtient pour ce deuxième exemple la valeur $V_{min}^{Z23}$ du premier paramètre P1 et la valeur $\frac{dQ_{dch}^{Z23}}{dV}$ du deuxième paramètre P2.

Les expériences de la demanderesse ont permis d'obtenir également des performances de prédiction satisfaisantes avec la première extrémité E1 de la portion plane Z23.

Néanmoins, l'utilisation de l'algorithme KNN pour la deuxième technique T2 s'est avérée moins satisfaisante.

Pour des utilisations n'impliquant pas d'utiliser la quatrième zone Z4, une telle technique sera donc intéressante puisque les prédictions pourront être faites sans un cycle de mesure particulier.

Enfin, pour chacun des modes de réalisation décrits, il est à noter qu'il est possible d'utiliser la bonne détermination des valeurs prédites pour la capacité et la résistance en combinaison avec une technique de détermination du paramètre relatif à la durée de vie restante comme, par exemple par calcul du rapport de la capacité de la batterie à un instant donné sur la capacité de la batterie à l'état neuf ou initial dans les mêmes conditions de mesure (notamment dans les mêmes conditions de température) et/ou du rapport de la résistance de la batterie à un instant donné sur la capacité de la batterie à l'état neuf ou initial dans les mêmes conditions de mesure (notamment dans les mêmes conditions de température). Ces derniers paramètres peuvent être considérés ainsi comme des paramètres relatifs à la durée de vie restante.

**Revendications**

1. Procédé de prédiction d'un paramètre relatif à la durée de vie restante d'au moins un élément électrochimique (12) d'une batterie (10), l'au moins un élément électrochimique (12) présentant une résistance, une capacité et une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane s'étendant entre une première extrémité correspondant à une première valeur d'état de charge et une deuxième extrémité correspondant à une deuxième valeur d'état de charge, le procédé étant mis en œuvre par un calculateur (22), le procédé étant **caractérisé en ce qu'**il comprend les étapes de :

   - obtention des mesures de la tension et du courant de l'au moins un élément électrochimique (12) lors d'une décharge comprenant une extrémité de la portion plane et commençant à un instant initial,
   - détection d'une extrémité de la portion plane en utilisant un critère dépendant de la tension et du courant,
   - calcul des valeurs à l'extrémité détectée d'un premier paramètre et d'un deuxième paramètre, le premier paramètre étant un paramètre relatif à la tension et le deuxième paramètre étant un paramètre relatif à la quantité de charge perdue depuis l'instant initial,
   - prédiction de la résistance de l'au moins un élément électrochimique (12) par application d'une première fonction de prédiction sur des premiers paramètres d'entrée, les premiers paramètres d'entrée comprenant la valeur du premier paramètre à l'extrémité détectée et la valeur du deuxième paramètre à l'extrémité détectée, la première fonction de prédiction étant obtenue par une première technique d'apprentissage, pour obtenir une valeur de résistance prédite,

- prédiction de la capacité de l'au moins un élément électrochimique (12) par application d'une deuxième fonction de prédiction sur des deuxièmes paramètres d'entrée, les deuxièmes paramètres d'entrée comprenant la valeur du premier paramètre à l'extrémité détectée et la valeur du deuxième paramètre à l'extrémité détectée, la deuxième fonction de prédiction étant obtenue par une deuxième technique d'apprentissage, pour obtenir une valeur de capacité prédite, et

- prédiction d'un paramètre relatif à la durée de vie restante de l'au moins un élément électrochimique (12) à partir de la valeur de résistance prédite et de la valeur de capacité prédite.

2. Procédé de prédiction selon la revendication 1, dans lequel l'étape de prédiction d'un paramètre relatif à la durée de vie est mise en oeuvre par application d'une troisième fonction de prédiction sur des troisièmes paramètres d'entrée, les troisièmes paramètres d'entrée comprenant la valeur de la résistance prédite, la valeur de la capacité prédite, la valeur du premier paramètre à l'extrémité détectée et la valeur du deuxième paramètre à l'extrémité détectée, la troisième fonction de prédiction étant obtenue par une troisième technique d'apprentissage.

3. Procédé de prédiction selon la revendication 2, dans lequel, la troisième technique utilise un algorithme de vecteur autorégressif.

4. Procédé de prédiction selon l'une quelconque des revendications 1 à 3, dans lequel, lors de l'étape d'obtention, il est également obtenu des mesures de température de l'au moins un élément électrochimique (12) lors de la décharge et lors de l'étape de calcul, la valeur du courant à l'extrémité détectée et la valeur de la température à l'extrémité détectée sont également calculées, les premiers paramètres d'entrée et les deuxièmes paramètres d'entrée consistant en la valeur du courant à l'extrémité détectée, la valeur de la température à l'extrémité détectée, la valeur du premier paramètre et la valeur du deuxième paramètre.

5. Procédé de prédiction selon l'une quelconque des revendications 1 à 3, dans lequel, lors de l'étape de calcul, la valeur du courant à l'extrémité détectée et la valeur de la température à l'extrémité détectée sont également calculées, les premiers paramètres d'entrée consistant en la valeur du courant à l'extrémité détectée, la valeur de la température à l'extrémité détectée, la valeur du premier paramètre et la valeur du deuxième paramètre et les deuxièmes paramètres d'entrée consistant en la valeur du courant à l'extrémité détectée, la valeur de la température à l'extrémité détectée, la valeur du premier paramètre, la valeur du deuxième paramètre et la résistance estimée.

6. Procédé de prédiction selon l'une quelconque des revendications 1 à 5, dans lequel, la première technique utilise un algorithme choisi parmi un algorithme de forêts aléatoires, un algorithme de K plus proches voisins, un algorithme de régression à vecteurs de support et un algorithme de régression polynomiale et la deuxième technique utilise un algorithme choisi parmi un algorithme de forêts aléatoires et un algorithme de K plus proches voisins.

7. Procédé de prédiction selon l'une quelconque des revendications 1 à 6, dans lequel :

- lorsque l'extrémité détectée est la première extrémité, le premier paramètre est la tension et le deuxième paramètre est la dérivée de la quantité de charge perdue depuis l'instant initial par rapport à la tension, le critère utilisé à l'étape de détection étant que le deuxième paramètre soit inférieur à un seuil, ou

- lorsque l'extrémité détectée est la première extrémité, le premier paramètre est la tension et le deuxième paramètre est la quantité de charge perdue depuis l'instant initial, le critère de détection étant que la variation du premier paramètre à quantité de charge perdue fixée soit inférieure à un seuil.

8. Procédé de prédiction selon l'une quelconque des revendications 1 à 7, dans lequel l'au moins un élément électrochimique (12) est un élément électrochimique de type $LiFePO_4$, $LiMnFePO_4$ ou LVPF.

9. Calculateur (22) propre à prédire un paramètre relatif à la durée de vie restante d'au moins un élément électrochimique (12) d'une batterie (10), l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane s'étendant entre une première extrémité correspondant à une première valeur d'état de charge et une deuxième extrémité correspondant à une deuxième valeur d'état de charge, le calculateur (22) étant **caractérisé en ce qu'**il est propre à :

- obtenir des mesures de la tension et du courant de l'au moins un élément électrochimique (12) lors d'une décharge comprenant une extrémité de la portion plane et commençant à un instant initial,
- détecter une extrémité de la portion plane en utilisant un critère dépendant de la tension et du courant,

- calculer des valeurs à l'extrémité détectée d'un premier paramètre et d'un deuxième paramètre, le premier paramètre étant un paramètre relatif à la tension et le deuxième paramètre étant un paramètre relatif à la quantité de charge perdue depuis l'instant initial,

- prédire la résistance de l'au moins un élément électrochimique (12) par application d'une première fonction de prédiction sur des premiers paramètres d'entrée, les premiers paramètres d'entrée comprenant la valeur du premier paramètre à l'extrémité détectée et la valeur du deuxième paramètre à l'extrémité détectée, la première fonction de prédiction étant obtenue par une première technique d'apprentissage, pour obtenir une valeur de résistance prédite,

- prédire la capacité l'au moins un élément électrochimique (12) par application d'une deuxième fonction de prédiction sur des deuxièmes paramètres d'entrée, les deuxièmes paramètres d'entrée comprenant la valeur du premier paramètre à l'extrémité détectée et la valeur du deuxième paramètre à l'extrémité détectée, la deuxième fonction de prédiction étant obtenue par une deuxième technique d'apprentissage, pour obtenir une valeur de capacité prédite, et

- prédire un paramètre relatif à la durée de vie restante de l'au moins un élément électrochimique (12) à partir de la valeur de résistance prédite et de la valeur de capacité prédite.

10. Système de gestion (14) d'au moins un élément électrochimique (12) d'une batterie (10), l'au moins un élément électrochimique (12) présentant des bornes et une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane s'étendant entre une première extrémité correspondant à une première valeur d'état de charge et une deuxième extrémité correspondant à une deuxième valeur d'état de charge, le système de gestion (14) comprenant :

- un capteur de tension (16) propre à mesurer la tension aux bornes dudit au moins un élément électrochimique (12) lors d'une décharge comprenant la portion plane,

- un capteur du courant aux bornes dudit au moins un élément électrochimique (12) lors d'une décharge comprenant la portion plane, et

- un calculateur (22) selon la revendication 9.

11. Batterie (10) comprenant :

- au moins un élément électrochimique (12), l'au moins un élément électrochimique (12) présentant des bornes et une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane s'étendant entre une première extrémité correspondant à une première valeur d'état de charge et une deuxième extrémité correspondant à une deuxième valeur d'état de charge, et

- un système de gestion (14) selon la revendication 10.

**Patentansprüche**

1. Vorhersageverfahren eines Parameters in Bezug auf die Restlebensdauer mindestens einer elektrochemischen Zelle (12) einer Batterie (10), wobei die mindestens eine elektrochemische Zelle (12) einen Widerstand, eine Kapazität und eine Kennlinie für Ladezustand (SOC)/ Leerlaufspannung (OCV) mit einem flachen Abschnitt aufweist, ein flacher Abschnitt ein Abschnitt ist, in dem die Variation der Leerlaufspannung (OCV) kleiner als 30 mV bei einer Variation von mindestens 10 % des Ladezustands (SOC) ist, wobei sich der flache Abschnitt zwischen einem ersten Ende, das einem ersten Wert des Ladezustands entspricht, und einem zweiten Ende, das einem zweiten Wert des Ladezustands entspricht, erstreckt, wobei das Verfahren von einem Rechner (22) implementiert wird, wobei das Verfahren **dadurch gekennzeichnet ist, dass** es die folgenden Schritte umfasst:

- Erlangung von Messungen der Spannung und des Stroms von mindestens einer elektrochemischen Zelle (12) während einer Entladung, umfassend ein Ende des flachen Abschnitts und beginnend an einem Anfangszeitpunkt,

- Erfassung eines Endes des flachen Abschnitts unter Verwendung eines spannungs- und stromabhängigen Kriteriums,

- Berechnung der Werte an dem erfassten Ende eines ersten Parameters und eines zweiten Parameters, wobei der erste Parameter ein Parameter in Bezug auf die Spannung ist, und der zweite Parameter ein Parameter in Bezug auf die Menge an Ladung ist, die seit dem Anfangszeitpunkt verloren wurde,

- Vorhersage des Widerstands von mindestens einer elektrochemischen Zelle (12) durch Anwendung einer ersten Vorhersagefunktion auf erste Eingangsparameter, die ersten Eingangsparameter umfassend den Wert des ersten Parameters an dem erfassten Ende und den Wert des zweiten Parameters an dem erfassten Ende, wobei die erste Vorhersagefunktion durch eine erste Lerntechnik erlangt wird, um einen vorhergesagten Widerstandswert zu erlangen,
- Vorhersage der Kapazität von mindestens einer elektrochemischen Zelle (12) durch Anwendung einer zweiten Vorhersagefunktion auf zweite Eingangsparameter, die zweiten Eingangsparameter umfassend den Wert des ersten Parameters an dem erfassten Ende und den Wert des zweiten Parameters an dem erfassten Ende, wobei die zweite Vorhersagefunktion durch eine zweite Lerntechnik erlangt wird, um einen vorhergesagten Kapazitätswert zu erlangen, und
- Vorhersage eines Parameters in Bezug auf die Restlebensdauer von mindestens einer elektrochemischen Zelle (12) anhand des vorhergesagten Widerstandswerts und des vorhergesagten Kapazitätswerts.

2. Vorhersageverfahren nach Anspruch 1, wobei der Vorhersageschritt eines Parameters in Bezug auf die Lebensdauer durch Anwendung einer dritten Vorhersagefunktion auf dritte Eingangsparameter implementiert wird, die dritten Eingangsparameter umfassend den Wert des vorhergesagten Widerstands, den Wert der vorhergesagten Kapazität, den Wert des ersten Parameters an dem erfassten Ende und den Wert des zweiten Parameters an dem erfassten Ende, wobei die dritte Vorhersagefunktion durch eine dritte Lerntechnik erlangt wird.

3. Vorhersageverfahren nach Anspruch 2, wobei die dritte Technik einen autoregressiven Vektoralgorithmus verwendet.

4. Vorhersageverfahren nach einem der Ansprüche 1 bis 3, wobei bei dem Erlangungsschritt auch Temperaturmessungen von mindestens einer elektrochemischen Zelle (12) während der Entladung erlangt werden und bei dem Berechnungsschritt auch der Wert des Stroms an dem erfassten Ende und der Wert der Temperatur an dem erfassten Ende berechnet werden, wobei die ersten Eingangsparameter und die zweiten Eingangsparameter aus dem Wert des Stroms an dem erfassten Ende, dem Wert der Temperatur an dem erfassten Ende, dem Wert des ersten Parameters und dem Wert des zweiten Parameters bestehen.

5. Vorhersageverfahren nach einem der Ansprüche 1 bis 3, wobei bei dem Berechnungsschritt auch der Wert des Stroms an dem erfassten Ende und der Wert der Temperatur an dem erfassten Ende berechnet werden, wobei die ersten Eingangsparameter aus dem Wert des Stroms an dem erfassten Ende, dem Wert der Temperatur an dem erfassten Ende, dem Wert des ersten Parameters und dem Wert des zweiten Parameters bestehen, und die zweiten Eingangsparameter aus dem Wert des Stroms an dem erfassten Ende, dem Wert der Temperatur an dem erfassten Ende, dem Wert des ersten Parameters, dem Wert des zweiten Parameters und dem geschätzten Widerstand bestehen.

6. Vorhersageverfahren nach einem der Ansprüche 1 bis 5, wobei die erste Technik einen Algorithmus verwendet, der ausgewählt ist aus einem Random-Forest-Algorithmus, einem K-nächste-Nachbarn-Algorithmus, einem Unterstützungsvektor-Regressionsalgorithmus und einem Polynomregressionsalgorithmus, und die zweite Technik einen Algorithmus verwendet, der ausgewählt ist aus einem Random-Forest-Algorithmus und einem K-nächste-Nachbarn-Algorithmus.

7. Vorhersageverfahren nach einem der Ansprüche 1 bis 6, wobei:

   - wenn das erfasste Ende das erste Ende ist, der erste Parameter die Spannung ist und der zweite Parameter die Ableitung der seit dem Anfangszeitpunkt verlorenen Ladungsmenge in Bezug auf die Spannung ist, wobei das in dem Erfassungsschritt verwendete Kriterium ist, dass der zweite Parameter kleiner als ein Schwellenwert ist, oder
   - wenn das erfasste Ende das erste Ende ist, der erste Parameter die Spannung ist und der zweite Parameter die seit dem Anfangszeitpunkt verlorene Ladungsmenge ist, wobei das Erfassungskriterium darin besteht, dass die Variation des ersten Parameters bei festgelegter verlorener Ladungsmenge unter einem Schwellenwert ist.

8. Vorhersageverfahren nach einem der Ansprüche 1 bis 7, wobei die mindestens eine elektrochemische Zelle (12) eine elektrochemische Zelle vom Typ $LiFePQ_4$, $LiMnFePQ_4$ oder LVPF ist.

9. Rechner (22), der geeignet ist, um einen Parameter in Bezug auf die Restlebensdauer von mindestens einer elektrochemischen Zelle (12) einer Batterie (10) vorherzusagen, wobei die mindestens eine elektrochemische Zelle (12) eine Kennlinie für Ladezustand (SOC)/ Leerlaufspannung (OCV) mit einem flachen Abschnitt aufweist, ein flacher Abschnitt ein Abschnitt ist, in dem die Variation der Leerlaufspannung (OCV) kleiner als 30 mV bei einer Variation von mindestens 10 % des Ladezustands (SOC) ist, wobei sich der flache Abschnitt zwischen einem ersten Ende, das einem ersten Wert des Ladezustands entspricht, und einem zweiten Ende, das einem zweiten Wert des Ladezustands entspricht, erstreckt, wobei der Rechner (22) **dadurch gekennzeichnet ist, dass** er zu Folgendem geeignet ist:

- Erlangen von Messungen der Spannung und des Stroms von mindestens einer elektrochemischen Zelle (12) während einer Entladung, umfassend ein Ende des flachen Abschnitts und beginnend an einem Anfangszeitpunkt,
- Erfassen eines Endes des flachen Abschnitts unter Verwendung eines spannungs- und stromabhängigen Kriteriums,
- Berechnen der Werte an dem erfassten Ende eines ersten Parameters und eines zweiten Parameters, wobei der erste Parameter ein Parameter in Bezug auf die Spannung ist, und der zweite Parameter ein Parameter in Bezug auf die Menge an Ladung ist, die seit dem Anfangszeitpunkt verloren wurde,
- Vorhersagen des Widerstands von mindestens einer elektrochemischen Zelle (12) durch Anwendung einer ersten Vorhersagefunktion auf erste Eingangsparameter, die ersten Eingangsparameter umfassend den Wert des ersten Parameters an dem erfassten Ende und den Wert des zweiten Parameters an dem erfassten Ende, wobei die erste Vorhersagefunktion durch eine erste Lerntechnik erlangt wird, um einen vorhergesagten Widerstandswert zu erlangen,
- Vorhersagen der Kapazität von mindestens einer elektrochemischen Zelle (12) durch Anwendung einer zweiten Vorhersagefunktion auf zweite Eingangsparameter, die zweiten Eingangsparameter umfassend den Wert des ersten Parameters an dem erfassten Ende und den Wert des zweiten Parameters an dem erfassten Ende, wobei die zweite Vorhersagefunktion durch eine zweite Lerntechnik erlangt wird, um einen vorhergesagten Kapazitätswert zu erlangen, und
- Vorhersagen eines Parameters in Bezug auf die Restlebensdauer von mindestens einer elektrochemischen Zelle (12) anhand des vorhergesagten Widerstandswerts und des vorhergesagten Kapazitätswerts.

10. Managementsystem (14) mindestens einer elektrochemischen Zelle (12) einer Batterie (10), wobei die mindestens eine elektrochemische Zelle (12) Anschlüsse und eine Kennlinie für Ladezustand (SOC)/ Leerlaufspannung (OCV) mit einem flachen Abschnitt aufweist, ein flacher Abschnitt ein Abschnitt ist, in dem die Variation der Leerlaufspannung (OCV) kleiner als 30 mV bei einer Variation von mindestens 10 % des Ladezustands (SOC) ist, wobei sich der flache Abschnitt zwischen einem ersten Ende, das einem ersten Wert des Ladezustands entspricht, und einem zweiten Ende, das einem zweiten Wert des Ladezustands entspricht, erstreckt, das Managementsystem (14) umfassend:

- einen Spannungssensor (16), der geeignet ist, um die Spannung an den Anschlüssen mindestens einer elektrochemischen Zelle (12) bei einer Entladung zu messen, die den flachen Abschnitt umfasst,
- einen Sensor des Stroms an den Anschlüssen von mindestens einer elektrochemischen Zelle (12) bei einer Entladung, die den flachen Abschnitt umfasst, und
- einen Rechner (22) nach Anspruch 9.

11. Batterie (10), umfassend:

- mindestens eine elektrochemische Zelle (12), wobei die mindestens eine elektrochemische Zelle (12) Anschlüsse und eine Kennlinie für Ladezustand (SOC)/ Leerlaufspannung (OCV) mit einem flachen Abschnitt aufweist, ein flacher Abschnitt ein Abschnitt ist, in dem die Variation der Leerlaufspannung (OCV) kleiner als 30 mV bei einer Variation von mindestens 10 % des Ladezustands (SOC) ist, wobei sich der flache Abschnitt zwischen einem ersten Ende, das einem ersten Wert des Ladezustands entspricht, und einem zweiten Ende, das einem zweiten Wert des Ladezustands entspricht, erstreckt, und
- ein Managementsystem (14) nach Anspruch 10.

**Claims**

1. A method for predicting a parameter relating to the remaining life of at least one electrochemical cell (12) of a battery (10), the at least one electrochemical cell (12) having a resistance, a capacitance and an open circuit voltage (OCV) - state of charge (SOC) characteristic with a planar portion, a planar portion being a portion wherein the change of the open circuit voltage (OCV) is less than 30 mV for a change of at least 10% of the state of charge (SOC), the planar portion extending between a first limit corresponding to a first value of the state of charge and a second limit corresponding to a second value of the state of charge, the method being implemented by a calculator (22), the method being **characterized in that** it comprises the steps of:

- obtaining voltage and current measurements of at least one electrochemical cell (12) during a discharge comprising one limit of the planar portion and beginning at an initial instant,
- detecting one limit of the planar portion using a criterion depending on the voltage and the current,
- calculating the values at the detected limit of a first parameter and of a second parameter, the first parameter being a parameter relating to the voltage and the second parameter being a parameter relating to the amount of charge lost since the initial instant,
- predicting the resistance of the at least one electrochemical cell (12) by applying a first prediction function to first input parameters, the first input parameters comprising the value of the first parameter at the detected limit and the value of the second parameter at the detected limit, the first prediction function being obtained by a first learning technique, so as to obtain a value of a predicted resistance,
- predicting the capacitance of the at least one electrochemical cell (12) by applying a second prediction function to second input parameters, the second input parameters comprising the value of the first parameter at the detected limit and the value of the second parameter at the detected limit, the second prediction function being obtained by a second learning technique, so as to obtain a value of a predicted capacitance, and
- predicting a parameter relating to the remaining life of the at least one electrochemical cell (12) from the value of a predicted resistance and the value of a predicted capacitance.

2. The prediction method according to claim 1, wherein the step of predicting a parameter relating to the life is implemented by applying a third prediction function to third input parameters, the third input parameters comprising the value of the predicted resistance, the value of the predicted capacitance, the value of the first parameter at the detected limit and the value of the second parameter at the detected limit, the third prediction function being obtained by a third learning technique.

3. The prediction method according to claim 2, wherein the third technique uses a vector autoregressive algorithm.

4. The prediction method according to any of claims 1 to 3, wherein, during the obtaining step, temperature measurements of the at least one electrochemical cell (12) are also obtained during discharge and, during the calculation step, the value of the current at the detected limit and the value of the temperature at the detected limit are also calculated, the first input parameters and the second input parameters consisting of the value of the detected limit current, the value of the detected limit temperature, the value of the first parameter and the value of the second parameter.

5. The prediction method according to any of claims 1 to 3, wherein during the calculation step, the value of the detected limit current and the value of the detected limit temperature are also calculated, the first input parameters consisting of the detected limit current value, the detected limit temperature value, the value of the first parameter and the value of the second parameter and the second input parameters consisting of the value of the detected limit current, the value of the detected limit temperature, the value of the first parameter, the value of the second parameter and the estimated resistance.

6. The prediction method according to any of claims 1 to 5, wherein, the first technique uses an algorithm chosen amongst a random forest algorithm, a K-nearest neighbors algorithm, a support vector regression algorithm and a polynomial regression algorithm and the second technique uses an algorithm chosen amongst a random forest algorithm and a K-nearest neighbor algorithm.

7. The prediction method according to any of claims 1 to 6, wherein:

- when the detected limit is the first limit, the first parameter is the voltage and the second parameter is the derivative of the amount of charge lost since the initial instant with respect to the voltage, the criterion used during the detection step being that the second parameter is below a threshold, or
- when the detected limit is the first limit, the first parameter is the voltage and the second parameter is the amount of charge lost since the initial instant, the detection criterion being that the change of the first parameter with set amount of charge lost is below a threshold.

8. The prediction method according to any of claims 1 to 7, wherein the at least one electrochemical cell (12) is a LiFePO$_4$, LiMnFePO$_4$ or LVPF electrochemical cell.

9. A calculator (22) apt to predict a parameter relating to the remaining life of at least one electrochemical cell (12) of a battery (10), the at least one electrochemical cell (12) having an open circuit voltage (OCV) - state of charge (SOC) characteristic with a planar portion, a planar portion being a portion wherein the change of the open circuit voltage (OCV) is less than 30 mV for a change of at least 10% of the state of charge (SOC), the planar portion extending between a first limit corresponding to a first value of state of charge and a second limit corresponding to a second value of state of charge, the calculator (22) being **characterized in that** it is apt to:

- obtain voltage and current measurements of at least one electrochemical cell (12) during a discharge comprising one limit of the planar portion and beginning at an initial instant,
- detect one limit of the planar portion using a criterion depending on the voltage and the current,
- calculate values at the detected limit of a first parameter and a second parameter, the first parameter being a parameter relating to the voltage and the second parameter being a parameter relating to the amount of charge lost since the initial instant,
- predict the resistance of the at least one electrochemical cell (12) by applying a first prediction function to first input parameters, the first input parameters comprising the value of the first parameter at the detected limit and the value of the second parameter at the detected limit, the first prediction function being obtained by a first learning technique, so as to obtain a value of a predicted resistance,
- predict the capacitance of the at least one electrochemical cell (12) by applying a second prediction function to second input parameters, the second input parameters comprising the value of the first parameter at the detected limit and the value of the second parameter at the detected limit, the second prediction function being obtained by a second learning technique, so as to obtain a value of a predicted capacitance, and
- predict a parameter relating to the remaining life of the at least one electrochemical cell (12) from the value of a predicted resistance and the value of a predicted capacitance.

10. A management system (14) for at least one electrochemical cell (12) of a battery (10), the at least one electrochemical cell (12) having terminals and an open circuit voltage (OCV) - state of charge (SOC) characteristic with a planar portion, a planar portion being a portion wherein the change of the open circuit voltage (OCV) is less than 30 mV for a change of at least 10% of the state of charge (SOC), the planar portion extending between a first limit corresponding to a first value of the state of charge and a second limit corresponding to a second value of the state of charge, the management system (14) comprising:

- a voltage sensor (16) apt to measure the voltage across at least one electrochemical cell (12) during a discharge including the planar portion,
- a current sensor at the terminals of said at least one electrochemical cell (12) during a discharge comprising the planar portion, and

- a calculator (22) according to claim 9.

11. The battery (10) comprising:

- at least one electrochemical cell (12), the at least one electrochemical cell (12) having terminals and an open circuit voltage (OCV) - state of charge (SOC) characteristic with a planar portion, a planar portion being a portion wherein the change of the open circuit voltage (OCV) is less than 30 mV for a change of at least 10% of the state of charge (SOC), the planar portion extending between a first limit corresponding to a first value of the state of charge and a second limit corresponding to a second value of the state of charge, and
- a management system (14) according to claim 10.

10

12

16

18

20

22

14

**FIG.1**

FIG.2

```
┌─────────────────────┐
│         E50         │
└─────────────────────┘
           │
           ▼
┌─────────────────────┐
│         E52         │
└─────────────────────┘
           │
           ▼
┌─────────────────────┐
│         E54         │
└─────────────────────┘
           │
    ┌──────┴──────────────────┐
┌──────────────┐      ┌──────────────┐
│     E56      │      │     E58      │
└──────────────┘      └──────────────┘
    └──────┬──────────────────┘
           │
           ▼
┌─────────────────────┐
│         E60         │
└─────────────────────┘
```

# FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3364203 A1

**Littérature non-brevet citée dans la description**

- Remaining Useful Life Prediction for Lithium-Ion Batteries Based on Capacity Extimation and Box-Cox Transformation. **XUE QIAO et al.** IEEE Transactions on Vehicular Technology. IEEE, 23 November 2020, vol. 69

- Robust State of Health Extimation of Lithium-Ion Batteries Using Convolutionnal Neural Network and Random Forest. **NIANKAI YANG et al.** Arxiv.org. Cornell University Library, 20 October 2020